# EUROPEAN PATENT APPLICATION

(11) **EP 2 071 748 A1**
(43) Date of publication of application: **17.06.2009**
(21) Application number: 08162145.0
(22) Date of filing: 11.08.2008
(51) Int. Cl.: H04B 10/155, H01S 5/06, H01S 5/068, H01S 5/14

(54) **Control system and method for optical communication device application**

(30) Priority: 14.12.2007 JP 2007322752
(71) Applicant: Tecdia Co., Ltd., Tokyo 170-6020 (JP)
(72) Inventor: Koyama, Etsuo, Tokyo 170-6020 (JP); Nagai, Yasuo, Tokyo 194-0031 (JP)
(74) Representative: Müller, Enno

(57) **Abstract**

The invention concerns a control system and method for an optical communication device, such as a tunable laser. The temperature of the laser diode, operation wavelength and output power of the laser source are controlled by means of respective control loops driven by a CPU. Said CPU is adapted to first control the temperature of the diode so that it gets stabilized within a certain range before a control process of the other parameters is carried out.

## Description

### BACKGROUND OF THE INVENTION

### Technical Field

The present invention relates to control system and method for optical communication device application, particularly to those being realized by way of cooperative control of software and hardware consisting of complicated control circuits of the optical communication device with a sophisticated function.

### Description of Related Art

In the patent document 1, a wavelength tunable optical filter is proposed that eliminates the unstable contribution caused by scatter at the production, temperature change, and so on, thereby enabling the stable wavelength selection automatically.
In the patent document 2, there is described a control circuit of an optical amplifier for the optical communication use.
In the patent document 3, an optical communication system is described that maximizes the total Signal-to-Noise Ratio of the entire optical fiber transmission system.
In the patent document 4, an optical amplifier is described that suppresses a gain-wavelength property variation caused by the intensity variation of the input light, thereby making the property constant for a wide range of the intensity of the input light.
In the patent document 5, there is proposed an optical amplifier for suppressing the optical surge.
In the patent document 6, there is proposed an optical equalizing amplifier, which during amplifying a multiplexed wavelength light, equalizes the optical levels of a plurality of components with a different wavelength and maintains the output light level constant.
In the patent document 7, there is described a prior art for controlling the power level of optical signal so as to essentially reduce damages caused by defects in the downstream of the optical fiber path.
In the patent document 8, there is proposed a broadband optical amplifier dynamically controlling respective different stages of the amplifier, through combining controls of the gains, losses, and power of respective stages depending on inputs and desired output level. Thereby, the amplifier has a constant gain profile and enables to correct for ASE (Amplified Spontaneous Emission) noise and minimize gain tilt.
In the patent document 9, there is disclosed a prior art, in which instabilities in a process control device controlled based on a feedback(s) from one ore more sensor(s) are detected and discriminated.
In the patent document 10, there are disclosed an controlling apparatus and method capable of stably, rapidly controlling the control variables with a non-linear input-output property.
In the patent document 11, there is disclosed a system for controlling wavelength of laser light.
In the patent document 12, there are disclosed a wavelength tunable optical filter and a semiconductor laser apparatus with external cavity using the same.
In the patent document 13, there are disclosed an optical switch and an optical add/ drop multiplexer.

Regarding the patent document 1, a differential coefficient of the output with respect to applied voltage is detected and feedback control is so performed that the differential coefficient converges toward zero.
Regarding the patent document 2, an inverting amplifier realizes control that reduces output level of the optical amplifier responsive to the temporary increase of the reflected light intensity relative to the output of the amplifier.
Regarding the patent document 3, notch filters are selectively inserted, and gains of respective amplifiers in the system are controlled based on the measured Signal-to-Noise Ratio.
Regarding the patent document 4, there are provided a first optical amplifier including smaller total amount of atoms or ions capable the light amplification, a second optical amplifier including more than former, and a controller for maintaining the intensity of the output light signal constant.
Regarding the patent document 5, control is performed such that when received light signal turned off, a driver is controlled so as to drive a light emitting device to start operating and slowly enlarge its optical output thereafter.
Regarding the patent document 6, the ALC (Automatic Level Control) circuit controls so as to maintain the optical level constant and an AGBC (Automatic Gain Balance Control) circuit controls the attenuation level of a tunable optical attenuator so as to meet levels of light with particular two wavelengths.
Regarding the patent document 7, light signal powers are provided with via optoelectronic elements aligned along an optical fiber path and controlled by way of two steps. In the first step, defects in the downstream side of the optical fiber path are detected as a function of power of reflected light signal at the upper side. In the next step, the light signal power is automatically reduced in the upstream side at certain extent so as to essentially reduce the damage caused by the light signal at the downstream side.
Regarding the patent document 8, a multi-stage amplifier has a central control circuit for independently controlling each stage. The amplifier has a plurality of sequentially couple stages; and each stage operates as an attenuator stage, a sub-amplifier stage for setting gain, or a stage for setting the power level. The central control circuit determines which stage(s) should be actively controlled, regarding either the gain or the power level.
Regarding the patent document 9, signal is firstly measured in the process control loop and stored as signal data, then, stochastic analysis is performed, and the existence of the instability is determined as well as its/ their origin(s) thereafter.
Regarding the patent document 10, there is described an example that is applied feedforward, feedback, or PID control technique to, and has driving current, voltage and the power of a laser diode as inputs. The intensity of laser light is chosen as a control variable in the example.
Regarding the patent document 11, the wavelength tunable laser is provided with a temperature detecting element and a bias controller responsive to the detected temperature. The lasing wavelength of the wavelength tunable laser is maintained substantially constant, by adjusting the bias applied to the wavelength tunable laser depending on the temperature.
Regarding the patent document 12, the refractivity of the liquid crystal is controlled by adjusting the voltage applied between a silicon substrate and a transparent electrode.
Regarding the patent document 13, a wavelength(s) of the light reflected and/ or diffracted from the optical diffraction-reflection layer is/ are selectable by controlling the refractivity of the liquid crystal through voltage applied thereto.
[Patent document 1] Japanese Patent Application Laid-Open Publication No. H05-346564
[Patent document 2] Japanese Patent Application Laid-Open Publication No. H06-301073
[Patent document 3] Japanese Patent Application Laid-Open Publication No. H06-318916
[Patent document 4] Japanese Patent Application Laid-Open Publication No. H08-255940
[Patent document 5] Japanese Patent Application Laid-Open Publication No. H09-018415
[Patent document 6] Japanese Patent Application Laid-Open Publication No. H09-211507
[Patent document 7] Japanese Patent Application Laid-Open Publication No. 2000-013328
[Patent document 8] Japanese Patent Application Laid-Open Publication No. 2002-544710
[Patent document 9] Japanese Patent Application Laid-Open Publication No. 2005-514676
[Patent document 10] Japanese Patent Application Laid-Open Publication No. 2004-355113
[Patent document 11] Japanese Patent Application Laid-Open Publication No. 2007-533151
[Patent document 12] Japanese Patent Application Laid-Open Publication No. 2007-299773
[Patent document 13] Japanese Patent Application Laid-Open Publication No. 2007-240744

Optical communication devices are recently progressing in multi-function, high performance, and the like. Therefore, their control circuitry has become complicated. Accordingly, it is difficult to provide with a stable control circuitry based merely on classical hardware design. Then, there are marketed optical modules having high performance as optical devices, or systems characterized by corporative control realized by introducing certain software and combining the control circuit (hardware) and a CPU (software).

The inventor of the present invention noticed that optical devices generally have strong temperature dependence. Particularly, semiconductor optical devices are strongly sensitive to the temperature; therefore, temperature control has been performed by using temperature sensor. Regarding optical communication devices, the control to stabilize the temperature is firstly the most important thing. Persevering search and research have been performed day after day on what kind of program scheme is suitable to realize it, the inventor finally find the way to the present invention with bless of God. The objective of the present invention is to provide with control system and method for optical communication device application, the system and the method cooperatively controlling software and an optical device controller (hardware) contributing a plurality of loops, at least one of which having a singularity more than first order.

### SUMMARY OF THE INVENTION

In order to achieve the aforementioned objective, the present invention provide with following configurations.
According to one of the configurations, since each control variable does not necessarily have the same weight of control order, each control variable is assigned with a schedule priority in advance and the highest priority control variable (for example, temperature) is controlled to converge into a stable range. Further, the temperature is stable for a short interval; therefore, during the stability interval of the temperature, the control on the control variable (temperature here.) can be suspended, thereby the control can be scheduled to the other control variable as if multiplicity of the loops has decreased one order. The next control variable (or control schedule) can be freely set depending on device properties, operating environment and so on.
Next, software in accordance with the invention is preferably chosen as RTOS (Real Time OS). Owing to its scheduling function, the RTOS can assign task scheduling weights by using the function. Consider three control variables hereafter. It is possible to assign weights of processing order and time delays, with the aid of software, to respective control variables by considering mapping each variable to corresponding control task. The weight of processing order represents a priority of processing. With the aid of the RTOS, the highest priority task can be processed according to a certain schedule such as periodic processing. From the other point of view, it is not desirable to unnecessarily frequently assign CPU resource to the control of the stable control variable within a certain time interval. With the aid of the RTOS, it is possible to assign adequate time delay, which can contribute more sophisticate control. While designing control by using the control circuit consisting of hardware, gain margin, phase margin and so on should be suitably cared, it is possible to configure the control system and method without considering them.

(1) The invention of claim 1 provides with a control system for optical communication device application, the scheme comprising: an optical communication device with multiple loops, at least one of which have singularity more than first order; a plurality of electronic circuits, each for controlling mutually different control variable of the optical communication device; and a CPU for totally controlling said plurality of electronic circuits; wherein the CPU controls one of the electronic circuits with the highest priority to converge the corresponding control variable into a stable range, and then controls the other variables.

(2) The invention of claim 2 provides with the control system for optical communication device application as claimed in claim 1, wherein the CPU is configured to execute RTOS (Real Time OS), divides the control tasks for the respective control loops into a plurality of tasks, and by using the schedule function of the RTOS, assignments of priorities and time-weights, ordering of processes, and time delays are realized.

(3) The invention of claim 3 provides with the control system for optical communication device application according to any preceding claim, wherein the optical communication device has a strong temperature dependence; the CPU controls temperature chosen from a plurality of control variables with the highest priority to converge the temperature into a stable range, and then controls the other control variables in a short time interval during the temperature is in the stable range.

(4) The invention of claim 4 provides with the control system for optical communication device application as claimed in claim 1, wherein the optical communication device is a tunable laser diode; the CPU totally controls environmental temperature of a laser diode, operation wavelength of a tunable mirror, and LD output level as control variables of the optical communication device by controlling a laser diode temperature controller for controlling the environmental temperature of the laser diode, a tunable mirror wavelength controller for controlling the operation wavelength of the tunable mirror, and an LD output level controller for controlling the output level of the laser diode; and wherein the CPU controls the laser diode temperature controller with the highest priority to converge the temperature in a stable range, then controls the tunable mirror wavelength controller to converge the operation wavelength of the tunable mirror into the desired wavelength, and then controls the LD output level controller to converge the output level into the desired level.

(5) The invention of claim 5 provides with the control system for optical communication device application as claimed in claim 4, wherein the CPU is configured to execute RTOS; the CPU divides control tasks occurring by executing control programs into a temperature control task for controlling the laser diode temperature controller, an operation wavelength control task for controlling the tunable mirror wavelength controller, and an LD output level control task for controlling the LD output level controller; and wherein the CPU realizes assignments of priorities to each task, ordering of process, and time delays.

(6) The invention of claim 6 provides with a control method for optical communication device application, control being performed on an optical communication device comprising a plurality of electronic circuits, which make multiple loops with singularity more than first order, by using a CPU for totally controlling these electronic circuits, and each electronic circuit controlling a predetermined different control variable of the optical communication device, wherein the CPU controls one of the electronic circuits with the highest priority to converge the corresponding control variable into a stable range, and then controls the other variables.

(7) The invention of claim 7 provides with the control method for optical communication device application as claimed in claim 6, wherein the CPU is configured to execute RTOS (Real Time OS), divides the control tasks for the respective control loops into a plurality of tasks, and by using the schedule function of the RTOS, assignments of priorities and time-weights, ordering of processes, and time delays are realized.

(8) The invention of claim 8 provides with the control method for optical communication device application as claimed in claim 6 or 7, wherein the optical communication device has a strong temperature dependence; the CPU controls temperature chosen from a plurality of control variables with the highest priority to converge the temperature into a stable range, and then controls the other control variables in a short time interval during the temperature is in the stable range.

(9) The invention of claim 9 provides with the control method for optical communication device application as claimed in claim 6, wherein the optical communication device is a tunable laser diode; the CPU totally controls environmental temperature of a laser diode, operation wavelength of a tunable mirror, and LD output level as control variables of the optical communication device by controlling a laser diode temperature controller for controlling the environmental temperature of the laser diode, a tunable mirror wavelength controller for controlling the operation wavelength of the tunable mirror, and an LD output level controller for controlling the output level of the laser diode; and wherein the CPU controls the laser diode temperature controller with the highest priority to converge the temperature in a stable range, then controls the tunable mirror wavelength controller to converge the operation wavelength of the tunable mirror into the desired wavelength, and then controls the LD output level controller to converge the output level into the desired level.

(10) The invention of claim 10 provides with the control method for optical communication device application as claimed in claim 9, wherein the CPU is configured to execute RTOS; the CPU divides control tasks occurring by executing control programs into a temperature control task for controlling the laser diode temperature controller, an operation wavelength control task for controlling the tunable mirror wavelength controller, and an LD output level control task for controlling the LD output level controller; and wherein the CPU realizes assignments of priorities to each task, ordering of process, and time delays.

### [Advantage of the Invention]

According to the invention of claim 1 or 6, it is possible to realize stable operation of the multiple control loops, at least one of which have singularity more than first order, without relying on a complicated hardware design.

According to the invention of claim 2 or 7, in addition to the aforementioned advantage of claim 1 or 6 respectively, it is possible to provide with control system and control method that can realize stable operation of an optical communication device with multiple control loops, at least one of which have singularity more than first order, with the aid of function of OS.

According to the invention of claim 3 or 8, in addition to the aforementioned advantage of claim 1 or 6 respectively, it is possible to provide with control system and control method that can control temperature with the highest priority and also the other control variables during the temperature is stable.

According to the invention of claim 4 or 9, in addition to the aforementioned advantage of claim 1 or 6 respectively, it is possible to provide with control system and control method suitable for a tunable laser diode.

According to the invention of claim 5 or 10, in addition to the aforementioned advantage of claim 4 or 9 respectively, it is possible to provide with control system and control method suitable for a tunable laser diode with the aid of function of OS.

### BRIEF DESCRIPTION OF THE DRAWINGS

FIG. 1 is a view illustrating an exemplary configuration of control circuits of the tunable laser diode of the prior art.
FIG. 2 is a block diagram illustrating the configuration of the control in accordance with the present invention.
FIG. 3 is a view for explaining the application of the scheduling function of the RTOS to the control process, in accordance with the present invention.
FIG. 4 is a view schematically illustrating a tunable LED module proposed by the present inventor.

### DETAILED DESCRIPTION OF THE PREFERRED EMBODIMENTS

Hereinafter, referring to the accompanying drawings illustrating exemplary configurations, descriptions are made on embodiments according to the present invention.

### [Example 1]

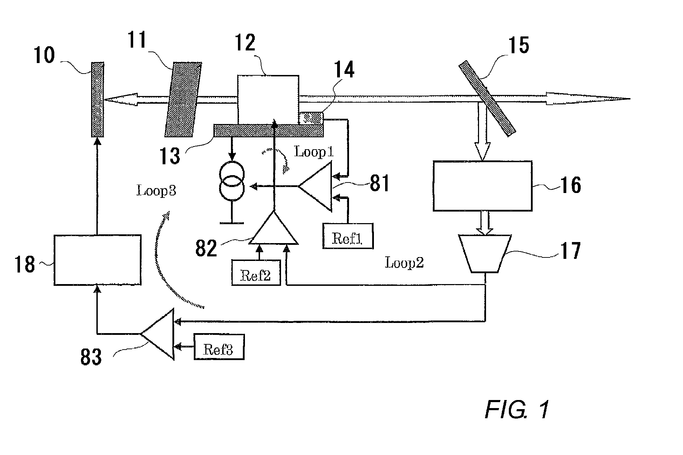

FIG. 1 is a view illustrating an exemplary configuration of control circuits of the tunable laser diode of the prior art. There are three control loops in this tunable laser diode. The control loop 1 is a closed loop for the temperature control of a laser diode 12; the operational amplifier 81 operates so as to diminish the deviation of the output of the temperature sensor (for example, thermistor) 14 from that of a Ref 1 (target temperature signal generator). Here, the temperature sensor 14 measures environmental temperature of the laser diode 12. The control loop 3 is a closed loop for the lasing wavelength control. Here, the lasing wavelength is detected by depicting a part of the laser beam from the laser diode 12 by means of a beam splitter 15, discriminating the wavelength by means of a wavelength discriminator 16, and then performing the optoelectronic transformation by means of photodiode 17. The wavelength discriminator 16 is configured, for example, by an etalon of which transmission peak wavelength is so shifted a little from the desired wavelength that the wavelength corresponds to the intensity of its transmitted light. The operational amplifier 83 affects the tunable mirror 10 by way of the wavelength selection voltage generator 18 so as to diminish the deviation of the output of the photodiode 17 from that of Ref 3 (target wavelength signal generator). The control loop 2 is a closed loop for controlling the output level of the laser; the operational amplifier 82 operates so as to diminish the deviation of the output of the photo diode 17 from that of Ref 2 (target level signal generator).

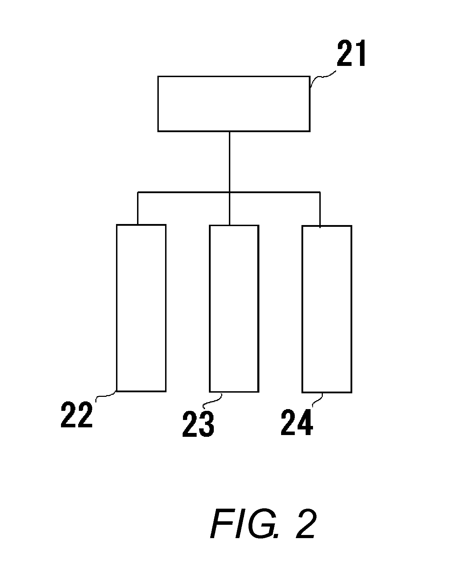

FIG. 2 is a block diagram illustrating the configuration of the control in accordance with the present invention. The CPU 21 is a central processing unit and may be configured as a micro-processor. In order to make small, it is also possible to use a so-called one-chip micro-computer. Further, depending on the size and/ or application of the optical device to be controlled, it is also possible to use a general purpose computer such as a so-called personal computer, an FA computer used for the factory automation, etc. Although the CPU 21 operates using RAM (Random Access Memory), ROM (Read Only Memory) and the like, their illustrations are omitted in order to avoid the complication. The ROM not shown stores, for example, an OS such as RTOS (Real Time OS), application programs, etc., the CPU 21, if necessary, reads out them and executes.

A temperature controller 22, a tunable mirror wavelength controller (hereinafter, referred to as "TM wavelength controller) 23 and an LD output level controller 24 is electrically connected to the CPU 21. The CPU 21 reads to execute necessary programs thereby controlling these controller 22∼24 totally. Here the temperature controller 22 is a hardware which includes the temperature sensor 14, the operational amplifier 81, and the Ref 1 (target temperature signal generator) shown in FIG. 1. The TM wavelength controller 23 is a hardware which includes the wavelength selection voltage generator 18, the operational amplifier 83 and Ref 3 (target wavelength signal generator) shown in FIG. 1. The LD output level controller 24 is a hardware which includes the operational amplifier 82 and Ref 2 (target output level signal generator) shown in FIG. 1.

The tunable laser diode is referred as an example having strong temperature dependence. There is described that the three controllers 22∼24, which are hardware, are electrically connected to the CPU 21 shown in FIG. 2 and totally controlled, so far. However, it is possible to consider a mapping from this hardware configuration to a software configuration, in which control programs are provided for the corresponding control hardware respectively, thereby occurring controls tasks by their execution.

Then according to the present invention, the temperature control task (i.e., task for controlling the temperature controller 22; hereinafter, other kind of tasks follow this nomenclature) is selected as the highest priority task. Regarding optical devices with strong temperature dependence, CPU resources are assigned with the highest priority to the temperature control task, which makes temperature stable. Thereby, it is possible to virtually reduce the order of singularity of the transfer function specifying the other control loops, by one order. This results in increased temperature stability. According to the present invention, each control task is assigned with priority and time weight.

The temperature control task is executed based on the output of the temperature sensor 14 so as to stabilize the environmental temperature of the laser diode 12. By executing this task first, the temperature dependent portion properties of laser diode 12 is maintained constant for a short interval; for example, those of the lasing wavelength, the threshold current that affects the driving current, and so on become constant (loop 1).

Next, by way of the wavelength control task, control voltage is applied so as that the operating wavelength of the tunable mirror becomes the target wavelength; thereby the wavelength becomes stable before the appreciable change of the temperature controlled in the former task. Therefore, the output of the photodiode (PD) converges into constant, wherein the output corresponds to the wavelength (loop 3); in other words, the deviation signal of the wavelength converges into a small range.

Further, after this, by way of the laser output level control task, control is performed so as to reduce the deviation of the output of the PD from the output (i.e., target output level) of the Ref 2 (loop 2).

In order to simplify the configuration, it is possible to set the execution order, the time interval, and so on of these control tasks the same. However, execution order, control intervals and/ or the like of these control tasks are freely adjustable depending on such as their priorities, by using the scheduling function of the TROS. According to the present invention, it is achievable the stable configuration and operation of the control system with singularity more than first and multiple loops, by applying RTOS like this.

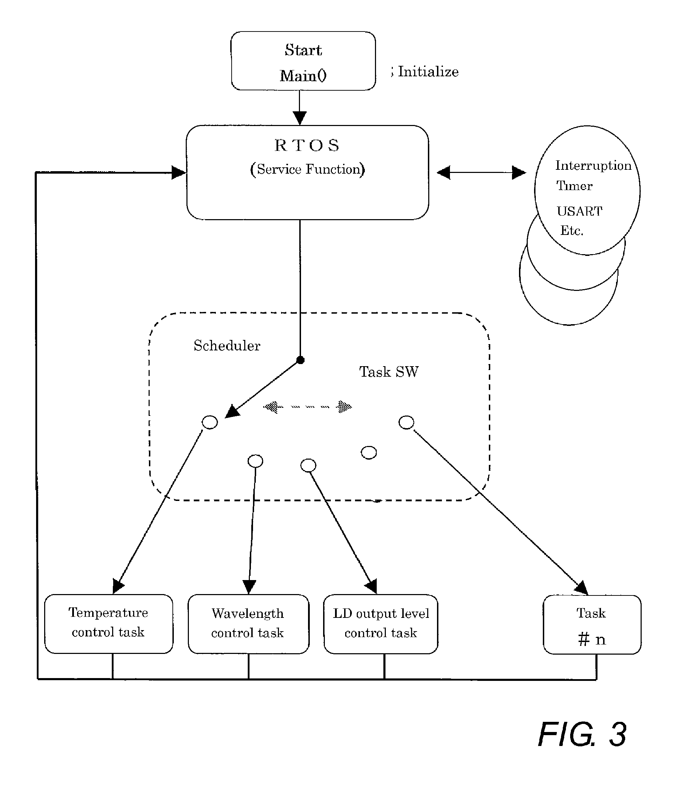

FIG. 3 is a view for explaining the application of the scheduling function of the RTOS to the control process, in accordance with the present invention. There is the temperature control task as the highest priority task, and the others as lower priority tasks: such as the wavelength control task, the laser output level control task and other kind of tasks 4∼n. Service functions, which notify event, information, and so on to a client, are provided with as programs in order to message, for example the control task things, to the RTOS. For example, one of them notifies an interruption event to the RTOS thereby making possible to execute the designated task while suspending the interrupted task. Further, the other enables to start a designated task from a current task after suspension of the current task. Recovering the original task is predetermined depending on each service function, and for example achievable in interruption allowed state, interruption forbidden state, or so on.

As the states of task, there are three states, i.e., blocked, suspended, and execution state; switching between these states is caused by the action of service functions responding to the occurrence of the interruption, execution event of the other task, and so on. A task SW (switch) switches respective tasks based on the scheduling rules (event driven, time slice, priority, and so on). According to the present invention, the temperature control task is executed first; the other tasks are booted and then suspended maintaining default values until the task SW recovers the execution. When temperature has become stable by way of the temperature control task, the other respective tasks are executed in a certain order after the assignment of the CPU resources.

### [Example 2]

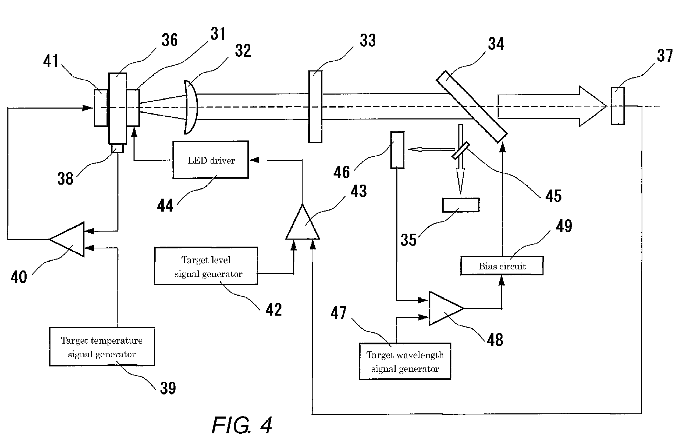

The present inventor also invented a control system of a tunable LED module and a wavelength selector together with the aforementioned invention. FIG. 4 is a view schematically illustrating a tunable LED module proposed by the present inventor. The tunable LED module comprises an LED 31, a collimator 32, an etalon 33, a BRF (Band Rejection Filter) 34, an optical coupler 35, an LED supporting member 36, and an optical receiver 37. The LED 31 is capable of emitting within a certain wavelength band including the target wavelength. The collimator 32 collimates the divergent light emanating form the LED 31. The etalon 33 works as a wavelength selector which selects a plurality of certain wavelengths including the target wavelength from those of the light emanating from the LED 31. The BRF 34 works as a wavelength tuner which is capable of selectively tuning the target wavelength within the wavelengths selected by the wavelength selector. To the optical coupler 35, the light of which wavelength is tuned by the BRF 34 enters and couples. The LED supporting member 36 is made from a material with a high thermal conductivity, such as copper and copper alloys, and supports the LED 31. The optical receiver 37 detects the power of the light with wavelengths not filtered out by the BRF 34 and generates selected level signal representing the detected optical power.

The tunable LED module shown in FIG. 4 includes an LED thermal controlling unit consisting of a temperature sensor 38, a target temperature signal generator 39, a temperature controller (for example, an operational amplifier) 40 and a temperature adjust device 41. The temperature sensor 38 detects the temperature of the LED supporting member 36 and generates detected temperature signal representing the detected temperature. The target temperature signal generator 39 generates target temperature signal representing the target temperature. The temperature controller 40 has the detected temperature signal and target temperature signal as inputs, and outputs temperature control signal representing the temperature deviation from the target temperature, which is specified based on the inputs. The temperature adjust device 41 includes such as a Peltier element and adjusts the temperature of the LED supporting member 36 depending on the temperature control signal, which is output from the temperature controller 40. Here, the temperature sensor 38 is configured so as to have a thermo-electronic transforming element and may directly detect the temperature of the LED 31 as well as the LED supporting member 36. Further the temperature control signal is used for controlling the deviation from the target temperature within a certain range.

Further, the tunable LED module includes an LED level control unit consisting of the optical receiver 37, a target level signal generator 42, a level controller (for example, an operational amplifier) 43 and an LED driver 44. The optical receiver 37 has such as a photodiode for detecting the power of the light transmitting the BRF 34 without rejected by it and generates selected light level signal. The target level signal generator 42 generates target output level signal representing the target output level of the LED 31. The level controller 43 has the selected light level signal and the target output level signal as inputs and generates level control signal depending on the level deviation from the target level specified based on these inputs. The LED driver 44 drives the LED 31 based on the level control signal. Here, the aforementioned level control signal is used for controlling the level deviation from the target level within a certain range.

Moreover, the tunable LED module includes a wavelength control unit consisting of a half mirror 45, an optical receiver 46, a target wavelength signal generator 47, a wavelength controller (for example, an operational amplifier) 48 and a bias circuit 49. The half mirror 45 reflects for monitoring use a part of the light emanating from the BRF 34 toward the optical coupler 35 and transmits the remaining. The optical receiver 46 is configured similar to the optical receiver 37, detects the power of the light reflected by the half mirror 45, and generates reflected light power signal. The target wavelength signal generator 47 outputs target wavelength signal representing the target wavelength of the BRF 34. The wavelength controller 48 has the reflected light power signal and the target wavelength signal as inputs, and outputs wavelength control signal depending on the wavelength deviation from the target wavelength, the deviation being specified based on these inputs. The bias circuit 49 controls the rejection wavelength of the BRF 34 depending on the wavelength control signal from the wavelength controller 48, by way of, for example, adjusting voltage applied on the liquid crystal. Here, the aforementioned wavelength control signal is used for controlling the wavelength deviation from the target wavelength, i.e., desired wavelength, within a certain range.

There exist the LED temperature control unit, the LED level control unit and the wavelength control unit as electronic circuits (hardware). Each composes the feedback loop of the closed loop 1∼3. Since one of them relates to the temperature control, the present invention is applicable. That is, it is applicable by providing with a CPU for totally controlling these three controlling circuits, performing the temperature control task as the highest priority task, and executing the other tasks (controlling the other control circuits) after the temperature converges within the stable range. These tasks can be executed by way of the configuration similar to that shown in FIG. 2 and 3. Thus, the present invention is also applicable to light emitting device (LED) besides laser diodes.

### [Example 3]

The present inventor already proposed an optical receiver which uses the wavelength selector, too. The optical receiver includes a tunable mirror offered by the present assignee as a "wavelength selector" switching the wavelength. Although its detail description is omitted here, this has, similar to the aforementioned embodiments 1 and/ or 2, a plurality of control circuits including the temperature control circuit. Therefore, the present invention is applicable to this optical receiver.

### [Example 4]

Further, the present inventor is already proposed an optical LAN derived by the combination of the embodiment 2 and the embodiment 3, too. To this optical LAN, the present invention is similarly applicable.

### [Example 5]

The present invention is similarly applicable to the detection of the deviation from the tuning-point of the wavelength selector which composes the tunable light source with a tunable mirror, too.

### [Example 6]

Further, the present invention is similarly applicable to an optical shutter which includes a tunable mirror as a switch, too.

### [Example 7]

There is listed patent documents 1∼13, in which examples of the prior art are described, in the "Background of the Invention". The present invention is also applicable to these prior arts, because the temperature control is performed there together with the other control(s).

The system and method in accordance with the present invention is advantageous to controlling circuits or optical modules including an optical device sensitive to the temperature. Regarding controlling targets easily assignable the priorities, the present invention is advantageous.

The control system and method according to the present invention is applicable to the control of devices and so on including a multiple control loops with a higher order singularity. Particularly, it is advantageous to apply to the optical devices which necessitate temperature control. It is also applicable to devices which control control variables excluding the temperature and maintaining stable for a certain time interval (may be short) after the conversion into a stable range.

## Claims

1. A control system for optical communication device application, the scheme comprising: an optical communication device with multiple loops, at least one of which have singularity more than first order;
a plurality of electronic circuits, each for controlling mutually different control variable of the optical communication device; and
a CPU for totally controlling said plurality of electronic circuits;
wherein the CPU controls one of the electronic circuits with the highest priority to converge the corresponding control variable into a stable range, and then controls the other variables.

2. The control system for optical communication device application as claimed in claim 1, wherein the CPU is configured to execute RTOS (Real Time OS), divides the control tasks for the respective control loops into a plurality of tasks, and by using the schedule function of the RTOS, assignments of priorities and time-weights, ordering of processes, and time delays are realized.

3. The control system for optical communication device application according to any preceding claim, wherein the optical communication device has a strong temperature dependence; the CPU controls temperature chosen from a plurality of control variables with the highest priority to converge the temperature into a stable range, and then controls the other control variables in a short time interval during the temperature is in the stable range.

4. The control system for optical communication device application as claimed in claim 1, wherein the optical communication device is a tunable laser diode; the CPU totally controls environmental temperature of a laser diode, operation wavelength of a tunable mirror, and LD output level as control variables of the optical communication device by controlling a laser diode temperature controller for controlling the environmental temperature of the laser diode, a tunable mirror wavelength controller for controlling the operation wavelength of the tunable mirror, and an LD output level controller for controlling the output level of the laser diode; and wherein the CPU controls the laser diode temperature controller with the highest priority to converge the temperature in a stable range, then controls the tunable mirror wavelength controller to converge the operation wavelength of the tunable mirror into the desired wavelength, and then controls the LD output level controller to converge the output level into the desired level.

5. The control system for optical communication device application as claimed in claim 4, wherein the CPU is configured to execute RTOS; the CPU divides control tasks occurring by executing control programs into a temperature control task for controlling the laser diode temperature controller, an operation wavelength control task for controlling the tunable mirror wavelength controller, and an LD output level control task for controlling the LD output level controller; and wherein the CPU realizes assignments of priorities to each task, ordering of process, and time delays.

6. A control method for optical communication device application, control being performed on an optical communication device comprising a plurality of electronic circuits, which make multiple loops with singularity more than first order, by using a CPU for totally controlling these electronic circuits, and each electronic circuit controlling a predetermined different control variable of the optical communication device,
wherein the CPU controls one of the electronic circuits with the highest priority to converge the corresponding control variable into a stable range, and then controls the other variables.

7. The control method for optical communication device application as claimed in claim 6, wherein the CPU is configured to execute RTOS (Real Time OS), divides the control tasks for the respective control loops into a plurality of tasks, and by using the schedule function of the RTOS, assignments of priorities and time-weights, ordering of processes, and time delays are realized.

8. The control method for optical communication device application as claimed in claim 6 or 7, wherein the optical communication device has a strong temperature dependence; the CPU controls temperature chosen from a plurality of control variables with the highest priority to converge the temperature into a stable range, and then controls the other control variables in a short time interval during the temperature is in the stable range.

9. The control method for optical communication device application as claimed in claim 6, wherein the optical communication device is a tunable laser diode; the CPU totally controls environmental temperature of a laser diode, operation wavelength of a tunable mirror, and LD output level as control variables of the optical communication device by controlling a laser diode temperature controller for controlling the environmental temperature of the laser diode, a tunable mirror wavelength controller for controlling the operation wavelength of the tunable mirror, and an LD output level controller for controlling the output level of the laser diode; and wherein the CPU controls the laser diode temperature controller with the highest priority to converge the temperature in a stable range, then controls the tunable mirror wavelength controller to converge the operation wavelength of the tunable mirror into the desired wavelength, and then controls the LD output level controller to converge the output level into the desired level.

10. The control method for optical communication device application as claimed in claim 9, wherein the CPU is configured to execute RTOS; the CPU divides control tasks occurring by executing control programs into a temperature control task for controlling the laser diode temperature controller, an operation wavelength control task for controlling the tunable mirror wavelength controller, and an LD output level control task for controlling the LD output level controller; and wherein the CPU realizes assignments of priorities to each task, ordering of process, and time delays.
